# EUROPEAN PATENT APPLICATION

(11) **EP 2 178 351 A1**
(43) Date of publication of application: **21.04.2010**
(21) Application number: 08166714.9
(22) Date of filing: 15.10.2008
(51) Int. Cl.: H05K 3/10

(54) **Method for the manufacture of products including conductive tracks.**

(71) Applicant: Nederlandse Organisatie voor toegepast-natuurwetenschappelijk onderzoek TNO, 2628 VK Delft (NL)
(72) Inventor: Korbee, Roland Alexander, 6133 VR Sittard (NL)
(74) Representative: Hatzmann, Martin

(57) **Abstract**

Method for the manufacture of products including a conductive track, the method comprising steps of manufacturing a body part of the product, providing a mixture of a polymer or monomer and a component having a low molecular mass, providing the body part with said mixture in a shape which corresponds to the desired conductive track, and hardening the mixture. Continued with removing the component having a low molecular mass from the hardened mixture, resulting in a porous track support member and providing said support member with a conductive material. Preferrably, manufacturing of the product is performed by means of a two or more components molding process. A product made in such way may be arranged for enabling a liquid or gaseous medium, e.g. a coolant, to be fed through the porous support member, in order to cool the conductor when the product is in use.

## Description

The invention refers to a method for the manufacture of products including conductive tracks.

Molded products which comprise conductive metal tracks and electrical components are known as MID (Molded Interconnect Devices) products. At this moment two production methods are available that are dominant for the production of MID components, viz. LSD (Laser Direct Structuring) and 2k (two components) molding. With LDS a (1k) molded product is written by a laser, causing an additive in the polymer to be converted into a substance which operates as a catalyst for currentless metalizing (electroless plating). In a following step the product is hung in a metallization bath, as a result of which a copper layer will be deposited onto the irradiated locations. LDS enables to make copper tracks with a small width.

With another method, 2k molding, an MID product is made from two (or more) components, of which one is metallizable and the other is not. In an electroless plating bath a metal layer is deposited at the locations where the metallizable material is at he surface. This method is much less accurate and tracks can be made of not less than about 500 µm.

Against the advantage of the accuracy of LDS is the disadvantage that the method is less suitable for mass production than 2k molding and. moreover, less suitable for manufacturing real 3D products.

One aim of the present invention is to combine the advantages of both known methods, resulting in products having conductive tracks with a small width, e.g. of 100 µm and less, and which can be produced in mass.

According to the invention it is preferred that a method for the manufacture of products including a conductive track comprises the steps of:
- manufacturing a body part of the product;
- providing a mixture of a polymer or monomer and a component having a low molecular mass;
- providing the body part with said mixture in a shape which corresponds to the desired conductive track;
- hardening the mixture;
- removing the component having a low molecular mass from the hardened mixture, resulting in a porous track support member;
- providing said support member with a conductive material.

The body part may be manufactured separately in the first step, e.g. by molding, resulting in a ready-made product, which is submitted then to the further steps, i.e. in particular to the step in which the body part is provided with said mixture in a shape which corresponds to the desired conductive track.

It is, however, preferred that manufacturing of the body part, providing the body part with said mixture in a shape which corresponds to the desired conductive track, as well as hardening the mixture, is performed by means of a two or more components molding process which may be called 2k Molding, Multi-Component Molding, Two-Shot Molding or Multi-Shot Molding, Multi-Shot Over-Molding, in which two or more materials are combined in a single mold (see also http://www.distinctiveplastics.com/html/?id=2). For example, Multi-Shot Over-Molding is a process of molding one plastic over another in one mold. This can be a soft touch material over a harder substrate, a clear window in an opaque substrate or two different colors of the same material. This system offers many advantages over the traditional method of multiple molds and multiple presses. The process is much more accurate . The bonding of the different materials is superior as the substrate is still hot when the over-molding takes place. Also a savings is realized in one operator, one mold, one machine and one machine setup.

It may be preferred that the support member is provided with a conductive material mainly at one or more of its outer surfaces. However, as the support member is porous, it may optionally be preferred to fill the pores of the porous material with a conductive material.

If the support member is provided with a conductive material mainly at one or more of its outer surfaces, the remaining porous material of the support member can optionally be used for feeding a liquid or gaseous coolant through it, thus enabling the removal of heat emitted by the conductor and possibly -especially when the surrounding material, e.g. of the body part, has good heat conductive properties- by other component parts or hotspots in its vicinity.

The present invention includes products comprising a body part and a (i.e. at least one) porous track support member provided with a conductive material, manufactured by the method presented hereinbefore. As already indicated, such a product is excellently fit for enabling a liquid or gaseous medium, e.g. a coolant, to be fed through the porous support member(s).

Hereinafter the invention will be elucidated more in detail with reference to some figures.
Figure 1 shows a first exemplary embodiment of a product made by the method according the invention;
Figure 2 shows a second exemplary embodiment of a product made by the method according the invention.

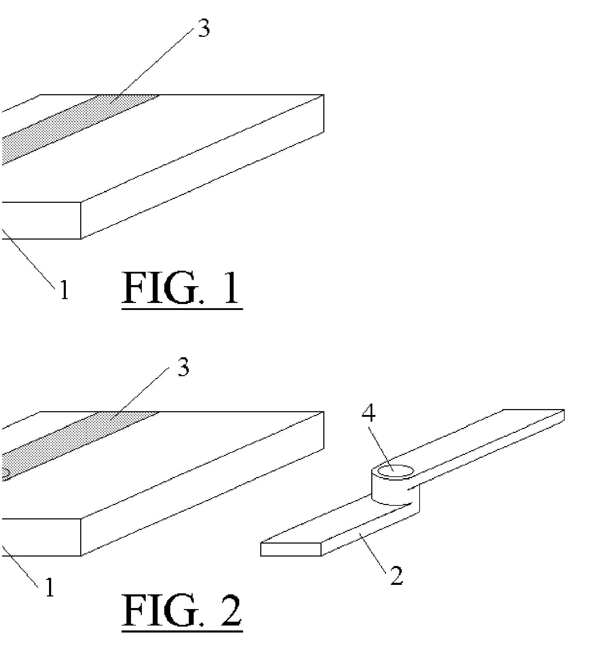

Figure 1 shows a first exemplary embodiment of a product, made by the method according the invention, comprising a body part 1 and a porous track support member 2 which is provided with a conductive material 3.

First of all the body part 1 of the product must be manufactured, which can be done by separate molding, resulting in a ready-made product, which is submitted then to the step in which the body part is provided with a mixture of a polymer or monomer and a component having a low molecular mass, applying it to the body part 1 in a shape which corresponds to the desired conductive track. It is, however, preferred that manufacturing of the body part, supplying the body part with the mixture including the low molecular mass component in a shape which corresponds to the desired conductive track, as well as hardening the mixture, is performed by means of a two or more components molding process, e.g. by Multi-Shot Over-Molding, where first the body part 1 is molded and the mixture including the low molecular mass component is molded -in a shape which corresponds to the desired conductive trackover the body part 1, in one mold. This process is very accurate since the body part 1 is kept in the same mold as where said mixture is processed (i.e. fed into the mold, evacuated and hardened). The bonding of both materials, i.e. the material of the body part 1 and the material of the track support member (i.e. the hardened mixture) is superior as the substrate is still hot when the over-molding takes place. The component having a low molecular mass is removed then -e.g. by evaporation, heating, rinsing with a liquid, e.g. water, etc.- from the hardened mixture, resulting in a porous track support member. The removing step may be performed inside or outside the mold. Finally the (porous) support member 2 is provided with a conductive material 3, thus forming the desired conductor.

The remaining porous material of the support member 2 can be used, by suitable arrangements, to feed a coolant through it when the product is in operation (and an electric current flows through it), thus cooling the conductor 3.

An example of a mixture which can be used for the above application is polyamide (PA) 46 which is molten and mixed then with e.g. 30 % diglycerol. That heat mixture thus is injected into the mold in which the body part 1, e.g. also made from PA46, already has been formed. As the mixture has a very low viscosity, this mixture is able to flow into and through very narrow (e.g. 100 µm and less) channels, which are previously formed in the body part 1. After cooling down (hardening) the mixture, phase segregation occurs and areas with PA 46 and areas with diglycerol are created. After extraction with e.g. water, a porous PA 46 support member 2 remains, which can be electroless galvanized.

Other examples of suitable mixtures are polypropene with paraffin and polycarbonate a liquid crystal polymer (LCP).

Figure 2 shows another product manufactured by the method according to the invention. In this second embodiment the support member has a more complex form, including a via 4 which extends through the thickness of the body part 1. After the support member 3 has been made in the way as outlined hereinbefore, the support member 2 is electroless galvanized (using any well known process), resulting in a conducting coating 3 on its outer surfaces.

## Claims

1. Method for the manufacture of products including a conductive track, the method comprising steps of:
- manufacturing a body part (1) of the product;
- providing a mixture of a polymer or monomer and a component having a low molecular mass;
- providing the body part with said mixture in a shape which corresponds to the desired conductive track;
- hardening the mixture;
- removing the component having a low molecular mass from the hardened mixture, resulting in a porous track support member (2);
- providing said support member with a conductive material (3).

2. Method according to claim 1, wherein manufacturing of the body part, providing the body part with said mixture in a shape which corresponds to the desired conductive track, as well as hardening the mixture, is performed by means of a two or more components molding process.

3. Method according to claim 1, wherein the support member is provided with a conductive material mainly at one or more of its outer surfaces.

4. Product, including a conductive track, manufactured by a method according to any of claims 1 - 3, a body part (1) and a porous track support member (2) provided with a conductive material (3).

5. Product according to claim 3 and 4, arranged for enabling a liquid or gaseous medium, e.g. a coolant, to be fed through the porous support member.
